# EUROPÄISCHE PATENTSCHRIFT

(11) **EP 0 444 433 B1**
(45) Veröffentlichungstag und Bekanntmachung des Hinweises auf die Patenterteilung: **25.06.1997**
(21) Anmeldenummer: 91101428.0
(22) Anmeldetag: 04.02.1991
(51) Int. Cl.: H03K 17/94, H03K 17/795

(54) **Schaltungsanordnung für Opto-Schmitt-Trigger**
Circuit arrangement for opto-electronic Schmitt trigger
Circuit pour trigger de Schmitt opto-électronique

(30) Priorität: 02.03.1990 DE 4006504
(43) Veröffentlichungstag der Anmeldung: 04.09.1991
(73) Patentinhaber: TEMIC TELEFUNKEN microelectronic GmbH, 74072 Heilbronn (DE)
(72) Erfinder: Mischel, Peter, Dr., W-7100 Heilbronn (DE); Schuch, Bernhard, W-8801 Neusitz (DE); Wicke, Ulrich, W-7101 Flein (DE)
(74) Vertreter: Maute, Hans-Jürgen, Dipl.-Ing.

(56) Entgegenhaltungen:
- EP-A- 0 067 448
- DD-A- 227 309
- DE-A- 3 411 995
- GB-A- 2 148 642
- US-A- 4 556 805
- NEW ELECTRONICS Bd. 15, Nr. 17, September 1982, LONDON, GB Seiten 58 - 59 B. DANCE: 'Monolithic light activated switches'

## Beschreibung

Die Erfindung betrifft eine Schaltungsanordnung gemäß dem Oberbegriff des Patentanspruchs 1, wie sie aus der EP 0 067 448 bekannt ist. Bei dieser optischen Empfangsschaltung wird in Abhängigkeit der einfallenden optischen Strahlung eine verstärkte und kompensierte Ausgangsspannung gewonnen.
Opto-Schmitt-Trigger werden als Strahlungsempfänger in Form einzelner Bauteile oder in Sensoren, beispielsweise in Gabel-/Reflex-Lichtschranken oder in Opto-lsolatoren eingesetzt. Der optische Empfangsteil, meist eine Fotodiode, dient zur Umwandiung der optischen Strahlung in ein elektrisches Signal, der elektronische Teil - Verstärker und Schmitt-Trigger - zur Verarbeitung des Eingangssignals; das Ausgangssignal wird am Schaltungsausgang abgegeben. Bei einem bestimmten Strahlungspegel des optischen Eingangssignals. das heißt beim Erreichen eines ersten Schwellwerts, wird das Ausgangssignal modifiziert; beim Erreichen eines zweiten Schwellwerts nimmt es wieder den ursprünglichen Wert an. Aufgrund der Schmitt-Trigger-Funktion erfolgt eine Pulsformung, wegen der eingebauten Hysterese werden Störsignale weitgehend unterdrückt.
In der DD 227 309 A1 wird eine Empfängerschaltung zum Regenerieren digitaler Signale beschrieben, bei der die von einer Fotodiode gelieferten Informationen mittels eines einen Transimpedanzverstärker aufweisenden Vorverstärkers und eines als Schmitt-Trigger ausgebildeten Hauptverstärkers in digitale Ausgangssignale umgewandelt werden.

Der Erfindung liegt die Aufgabe zugrunde, eine vorteilhafte Schaltungsanordnung gemäß dem Oberbegriff des Patentanspruchs 1 als Opto-Schmitt-Trigger anzugeben.
Dies wird erfindungsgemäß durch die Merkmale im Kennzeichen des Patentanspruchs 1 erreicht.

Vorteilhafte Weiterbildungen der Schaltungsanordnung ergeben sich aus den weiteren Patentansprüchen.

Es sind ,,active-LOW" und ,,active-HIGH"-Versionen der Schaltungsanordnung möglich, wobei in der ,,active-LOW"-Version der Ausgangstransistor bei vorhandener Beleuchtung beim Unterschreiten eines Schwellwerts eingeschaltet ist (LOW-Zustand).

Um einen statischen und dynamischen Gleichlauf der Potentiale an den beiden Eingängen der Differenzverstärkerstufe und damit eine möglichst gute Gleichtaktunterdrückung zu erreichen, wird die Transimpedanzverstärkerstufe durch das erste Referenznetzwerk und das Fotoempfangselement durch das Kompensationsglied nachgebildet.

Die Schwellwerte der Schmitt-Trigger-Stufe können durch Veränderung von Widerständen an unterschiedliche Signal-Grundpegel individuell angepaßt werden. Die Ausschaltschwelle darf dabei jedoch einen bestimmten Minimalwert nicht überschreiten, da auch bei Parameterschwankungen bzw. Exemplarstreuungen der Bauelemente ein sicheres Ausschalten gewährleistet werden muß.
Die Einschaltempfindlichkeit der Schmitt-Trigger-Stufe kann in Abhängigkeit der Temperatur verändert werden. Vorzugsweise wird die Empfindlichkeit derart verändert, daß sie mit steigender Temperatur zunimmt; dies dient dazu, den Temperatureinfluß auf die optische Strecke - beispielsweise in Opto-Kopplern zwischen LED und Fotodiode - teilweise zu kompensieren.

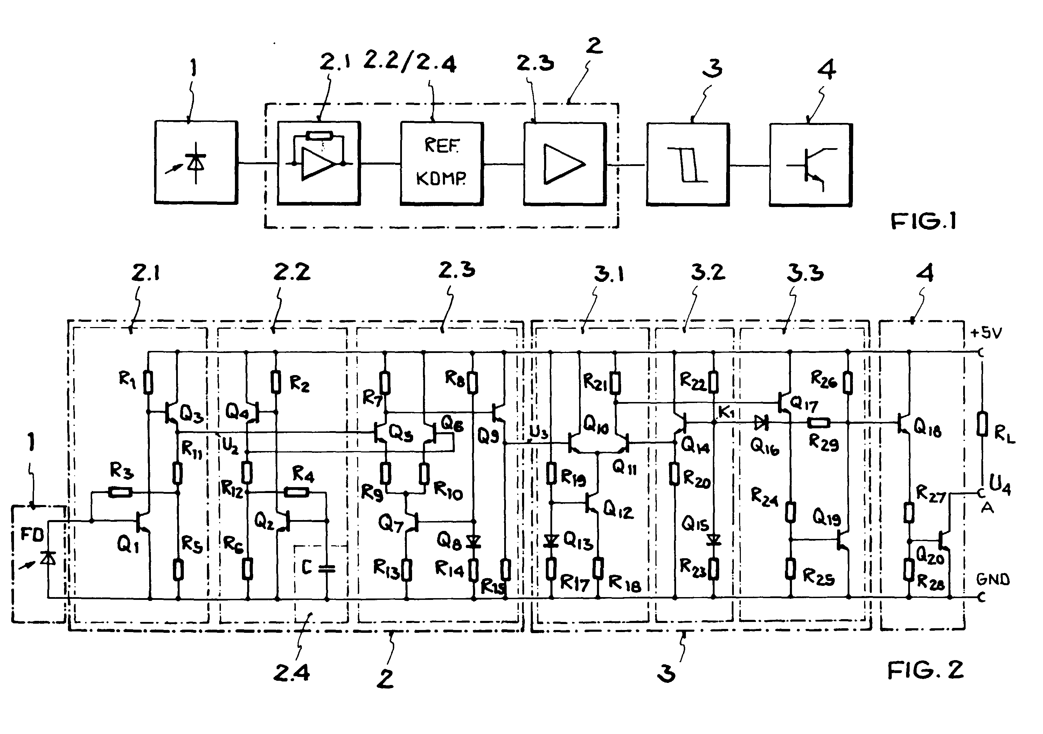

Die Schaltungsanordnung mit vorteilhaften Weiterbildungen wird im folgenden anhand der Figuren 1 bis 8 beschrieben.

Es zeigen:
- Figur 1: ein Blockschaltbild der Schaltungsanordnung,
- Figur 2: eine ,,active-LOW"-Version der Opto-Schmitt-Trigger-Schaltungsanordnung,
- Figur 3: Potential- und Signalverläufe der Schaltungsanordnung in Fig. 2,
- Figur 4: die Differenzverstärkerstufe der Verstärkerstufe einer "active-HiGH"-Version der Opto-Schmitt-Trigger-Schaltungsanordnung nach Figur 2,
- Figur 5: Potential- und Signalverläufe der Schaltungsanordnung gemäß Figur 4,
- Figur 6: die Schmitt-Trigger-Stufe einer Opto-Schmitt-Trigger-Schaltungsanordnung, deren Ein- und Ausschaltschwelle gezielt temperaturabhängig eingestellt ist,
- Figur 7: den Temperaturverlauf der Signale der Schaltungsanordnung nach Figur 6,
- Figur 8: eine weitere Ausführungsform der Opto-Schmitt-Trigger-Schaltungsanordnung mit der die Differenz zweier Fotoströme gebildet werden kann.
Im Blockschaltbild der Figur 1 sind die einzelnen Schaltungskomponenten der als Opto-Schmitt-Trigger ausgebildeten Schaltungsanordnung aufgeführt; diese Schaltungskomponenten sind auch in den Figuren 2, 4 und 6 als schematische Blöcke eingezeichnet.
Der monolithisch integrierte Opto-Schmitt-Trigger-IC besteht aus einer integrierten Fotodiode 1 als Fotoempfangselement, einer zweistufigen Verstärkerstufe 2 (Transimpedanzverstärkerstufe 2.1, Differenzverstärkerstufe 2.3, erstes Referenznetzwerk 2.2 und Kompensationsglied 2.4) mit nachgeschalteter Schmitt-Trigger-Stufe 3 sowie einer Ausgangsstufe 4.
In der Fotodiode 1 wird das optische Eingangssignal zunächst in ein elektrisches Signal (Fotostrom) umgewandelt. Die Transimpedanzverstärkerstufe 2.1 wandelt den Fotostrom in einen Spannungshub um, der durch die Differenzverstärkerstufe 2.3 verstärkt wird. In der Schmitt-Trigger-Stufe 3 wird eine Pulsformung unter Einbeziehung einer Hysterese vorgenommen; am Ausgangstransistor der Open-Kollektor-Ausgangsstufe 4 steht beispielsweise ein TTL-kompatibles Signal zur Verfügung.

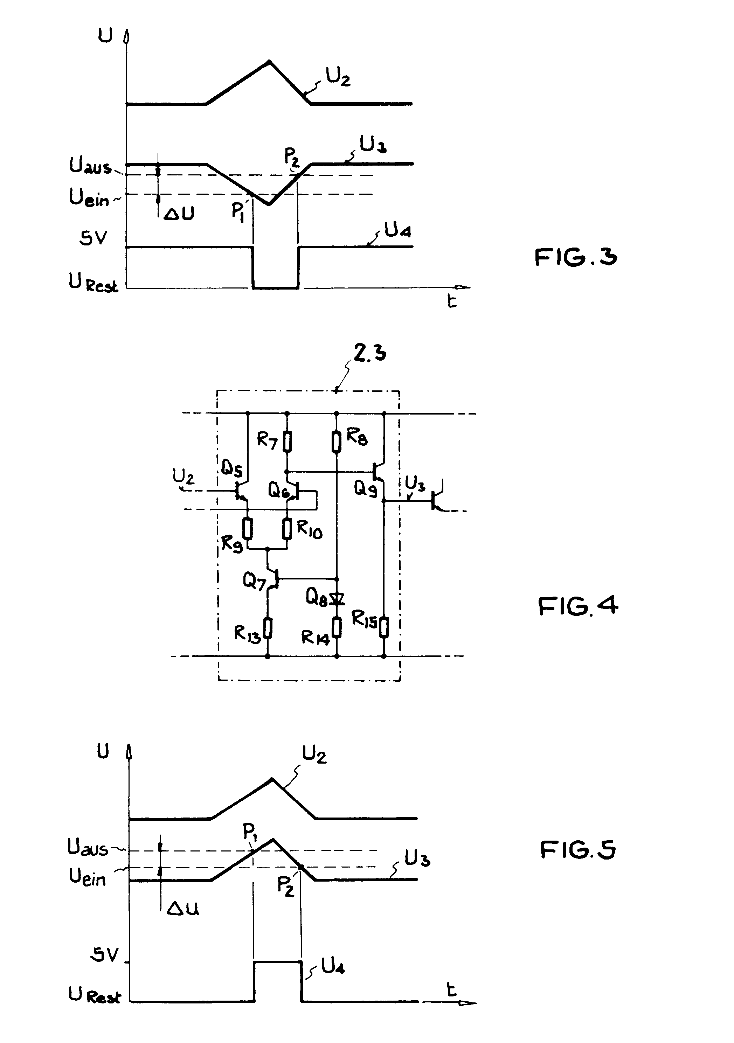

### Beispiel 1: "active-LOW"-Version (Fig. 2 und 3)

Gemäß dem Schaltbild der Figur 2 soll der Aufbau der einzelnen Schaltungskomponenten sowie deren Wirkungsweise näher beschrieben werden.

### 1. Fotodiode:

Die einfallende optische Strahlung wird durch die Fotodiode 1 detektiert und durch den Konversionswiderstand R₃ der Transimpedanzverstärkerstufe 2.1 in ein Spannungssignal umgewandelt.

### 2.1 Transimpedanzverstärkerstufe:

Die Transimpedanzverstärkerstufe 2.1 enthält neben dem Widerstand R₃ noch die Widerstände R₁, R₅ und R₁₁ sowie die Transistoren Q₁ und Q₃. Aufgrund der Schaltungskonfiguration wird die Eingangs-Zeitkonstante klein gehalten, so daß die Arbeitsfrequenz der Opto-Schmitt-Trigger-Schaltungsanordnung hoch ist. Der kathodenseitige Ausgang der Fotodiode 1 ist sowohl an den Widerstand R₃ als auch an die Basis des Transistors Q₁ angeschlossen; der Kollektor des Transistors Q₁ ist sowohl mit der Basis des Transistors Q₃ als auch mit einem Anschluß des Widerstands R₁ verbunden. Der Emitter des Transistors Q₃ führt sowohl zum Widerstand R₁₁, dessen anderer Anschluß mit den beiden Widerständen R₃ und R₅ verbunden ist, als auch zum Basisanschluß des ersten Transistors Q₅ des Differenzverstärkers der Differenzverstärkerstufe 2.3. Die Anode der Fotodiode 1, der Emitter des Transistors Q₁ und der zweite Anschluß des Widerstands R₅ sind an Massepotential (GND), der Kollektor des Transistors Q₃ sowie der zweite Anschluß des Widerstands R₁ an die Versorgungsspannung (bsp. + 5 V) angeschlossen.

### 2.2 Erstes Referenznetzwerk:

Das erste Referenznetzwerk 2.2 ist analog zur Transimpedanzverstärkerstufe 2.1 aufgebaut, wobei die Transistoren Q₂ und Q₄ des ersten Referenznetzwerks 2.2 den Transistoren Q₁ und Q₃ des Transimpedanzverstärkers 2.1, die Widerstände R₂, R₆ und R₁₂ des ersten Referenznetzwerks 2.2 den Widerständen R₁, R₅ und R₁₁ des Transimpedanzverstärkers 2.1 entsprechen.

Der Emitter des Transistors Q₄ ist dabei mit der Basis des zweiten Transistors Q₆ des Differenzverstärkers der Differenzverstärkerstufe 2.3 verbunden.

Durch diese Nachbildung der Transimpedanzverstärkerstufe 2.1 mittels des ersten Referenznetzwerks 2.2 wird ein statischer Gleichlauf der Basispotentiale der beiden den Differenzverstärker der Differenzverstärkerstufe 2.3 bildenden Transistoren Q₅, Q₆ erreicht. Einflüsse durch Schwankungen der Versorgungsspannung sowie technologisch bedingte Parameterschwankungen innerhalb der Transimpedanzverstärkerstufe 2.1 und des ersten Referenznetzwerks 2.2 kommen somit nicht zum Tragen. Durch das Fotoempfangselement (Fotodiode) 1 werden die dynamischen Eigenschaften der Transimpedanzverstärkerstufe 2.1 beeinflußt; um eventuell auftretende dynamische Störungen zu kompensieren, wird das Fotoempfangselement 1 durch das Kompensationsglied 2.4, beispielsweise durch den Kompensations-Kondensator C nachgebildet. Somit wird auch ein dynamischer Gleichlauf der Basispotentiale der beiden den Differenzverstärker der Differenzverstärkerstufe 2.3 bildenden Transistoren Q₅, Q₆ erreicht.

### 2.3 Differenzverstärkerstufe:

Diese besteht aus den Transistoren Q₅, Q₆, Q₇ und Q₉, der Diode Q₈, sowie den Widerständen R₇ bis R₁₀ und R₁₃ bis R₁₅. Die beiden Transistoren Q₅, Q₆ bilden den eigentlichen Differenzverstärker, wobei deren Basen, wie oben beschrieben, durch die Transimpedanzverstärkerstufe 2.1 bzw. das erste Referenznetzwerk 2.2 und mit Hilfe des Kompensationsglieds 2.4 im statischen und dynamischen Gleichlauf angesteuert werden. Die Emitter der Transistoren Q₅ bzw. Q₆ sind über die Widerstände R₉ bzw. R₁₀ an eine gemeinsame Stromquelle, den Kollektor des Transistors Q₇ angeschlossen; dieser wird durch den Spannungsteiler R₈, R₁₄ und Q₈ angesteuert, wobei die Basis des Transistors Q₇ mit der Anode der Diode Q₈ und dem Widerstand R8 verbunden ist. Der Emitter des Transistors Q₇ ist über den Widerstand R₁₃, die Kathode der Diode Q₈ über den Widerstand R₁₄ an Massepotential (GND) angeschlossen.
Das Ausgangssignal der Differenzverstärkerstufe 2.3 wird über den Abgriff am Kollektor des Transistors Q₅ sowie über den Emitterfolger-Transistor Q₉ und dessen Emitterwiderstand R₁₅ am Emitter des Emitterfolger-Transistors Q₉ als Spannung U₃ ausgegeben. Der Kollektorwiderstand R₇ des Transistors Q₅, der zweite Anschluß des Widerstands R₈ und die Kollektoren der Transistoren Q₆ und Q₉ sind an die Versorgungsspannung (+ 5 V) angeschlossen. Der zweite Anschluß des Emitterwiderstands R₁₅ ist mit Massepotential (GND) verbunden.

### 3. Schmitt-Trigger-Stufe

### 3.1 Differenzverstärkerstufe:

Die beiden Transistoren Q₁₀ und Q₁₁, deren Emitter miteinander und mit dem Kollektor des als Stromquelle arbeitenden Transistors Q₁₂ verbunden sind, bilden den "eigentlichen Schmitt-Trigger".
Der Kollektor des Transistors Q₁₀ ist direkt, der Kollektor des Transistors Q₁₁ über den Kollektorwiderstand R₂₁ mit der Versorgungsspannung (+ 5 V) verbunden. Die Basis des Transistors Q₁₂ wird von dem Spannungsteiler R₁₉, Diode Q₁₃ und R₁₇ angesteuert, wobei die Basis mit einem Anschluß des Widerstands R₁₉ sowie mit der Anode der Diode Q₁₃ verbunden ist; die Kathode der Diode Q₁₃ ist mit dem Widerstand R₁₇ verbunden. Der zweite Anschluß des Widerstands R₁₉ ist an die Versorgungsspannung (+ 5 V), der Widerstand R₁₇ und der Emitterwiderstand R₁₈ des Transistors Q₁₂ an Massepotential (GND) angeschlossen.

Das Basispotential des Transistors Q₁₀ wird durch den Spannungsausgang der Differenzverstärkerstufe 2.3 (Emitter des Transistors Q₉), das Basispotential des Transistors Q₁₁ vom Emitter des Transistors Q₁₄ des zweiten Referenznetzwerks 3.2 angesteuert. Der Abgriff am Kollektor des Transistors Q₁₁ ist mit der Basis des Transistors Q₁₇ im Mitkopplungszweig 3.3 verbunden.

### 3.2 Zweites Referenznetzwerk:

Das zweite Referenznetzwerk 3.2 liefert das Referenzpotential für die Basis des Transistors Q₁₁ und besteht aus dem Spannungsteiler R₂₂, Diode Q₁₅ und R₂₃ sowie dem Emitterfolger-Transistor Q₁₄ mit dem Emitterwiderstand R₂₀. Der Kollektor des Emitterfolger-Transistors Q₁₄ und der zweite Anschluß des Widerstands R₂₂ sind an die Versorgungsspannung (+ 5 V), der zweite Anschluß des Widerstands R₂₃, dessen anderer Anschluß mit der Kathode der Diode Q₁₅ verbunden ist, an Massepotential (GND) angeschlossen.

Die Anode der Diode Q₁₅, der erste Anschluß des Widerstands R₂₂ und die Basis des Emitterfolger-Transistors Q₁₄ sind mit dem Knotenpunkt K₁ verbunden, an welchem auch die Anode der Diode Q₁₆ des Mitkopplungszweigs 3.3 angeschlossen ist.

### 3.3 Mitkopplungszweig:

Die Mitkopplung in der Schmitt-Trigger-Stufe 3 wird im Mitkopplungszweig 3.3 mit Hilfe des Emitterfolger-Transistors Q₁₇, des Teilers aus den Widerständen R₂₄, R₂₅, des Transistors Q₁₉ in Emitterschaltung, dessen Kollektorwiderstands R₂₆ sowie der Diode Q₁₆ und des Widerstands R₂₉ erreicht.
Dabei ist im einzelnen die Basis des Emitterfolger-Transistors Q₁₇ an den Kollektor des Transistors Q₁₁, der Emitter an den ersten Anschluß des Widerstands R₂₄ und der Kollektor an die Versorgungsspannung (+ 5V) angeschlossen. Die Anode der Diode Q₁₆ ist mit der Basis des Emitterfolger-Transistrors Q₁₄, dem Widerstand R₂₂ und der Anode der Diode Q₁₅, die Kathode von Q₁₆ mit dem Widerstand R₂₉ verbunden, dessen anderer Anschluß an den Widerstand R₂₆, an den Kollektor des Transistors Q₁₉ und an die Basis des Emitterfolger-Transistors Q₁₈ angeschlossen ist. Die Basis des Transistors Q₁₉ wiederum ist mit dem zweiten Anschluß des Widerstands R₂₄ und mit dem Widerstand R₂₅ verbunden, dessen zweiter Anschluß und der Emitter des Transistors Q₁₉ an Massepotential (GND) angeschlossen sind. Der zweite Anschluß des Widerstands R₂₆ liegt an der Versorgungsspannung (+ 5V).
Die "Einschaltschwelle" der Schmitt-Trigger-Stufe 3 wird - bei der hier beschriebenen ,,active-LOW"-Version - durch den Widerstand R₂₉ und den Innenwiderstand des Netzwerks aus den Widerständen R₂₂ und R₂₃ eingestellt; sie kann durch Variation des Widerstands R₂₉ verändert werden, ohne daß die "Ausschaltschwelle" davon berührt wird. Die Ausschaltschwelle darf nicht beliebig bzw. ungewollt verändert werden, damit die Ausschaltbedingung für den Opto-Schmitt-Trigger gewährleistet bleibt.

In der Fig. 3 sind, von oben nach unten, die zeitlichen Verläufe der Eingangsspannung U₂ am Emitter des Transistors Q₃ der Transimpedanzverstärkerstufe 2.1, die Spannung U₃ am Ausgang der Verstärkerstufe 2 bzw. am Eingang der Schmitt-Trigger-Stufe 3 (Basispotential des Transistors Q₁₀) sowie die Spannung U₄ am Schaltungsausgang A der Ausgangsstufe 4 dargestellt. Der Einschaltvorgang in der ,,active-LOW"-Version gemäß Figur 2 wird nach Figur 3 dann erreicht, wenn bei Einstrahlung von Licht die Spannung U₂ so weit ansteigt, daß das Basispotential U₃ am Transistor Q₁₀ kleiner als die Spannung Uₑᵢₙ (Punkt P₁) wird, d.h. ein erster Schwellwert unterschritten wird. Dann übernimmt der Transistor Q₁₁ den gesamten Strom vom Transistor Q₁₂; über den Emitterfolger-Transistor Q₁₇ und den Spannungsteiler R₂₄, R₂₅ wird erreicht, daß der Transistor Q₁₉ sperrt. Dadurch geht aber auch die Diodenstrecke Q₁₆ mit dem Widerstand R₂₉ in den Sperrzustand über. Der Spannungsteiler R₂₂, Q₁₅, R₂₃ wird dann durch den Zweig mit der Diode Q₁₆ nicht belastet, folglich steigt das Emitterpotential des Transistors Q₁₄ bzw. das Basispotential des Transistors Q₁₁ an. Das für den Ausschaltvorgang erforderliche Potential wird durch den Punkt P₂ bestimmt, (Überschreiten eines zweiten Schwellwerts), so daß der typische Hystereseverlauf eines Schmitt-Triggers erreicht wird.
Beim Ausschaltvorgang in der "active-LOW"-Version, d.h. bei Wegfall der Bestrahlung, fällt die Spannung U₂ so weit ab (Punkt P₂), daß der Transistor Q₁₀ in den leitenden Zustand übergeht. Der Transistor Q₁₀ übernimmt den vollen Strom der Stromquelle Q₁₂, der Transistor Q₁₁ sperrt. Durch den Emitterfolger-Transistor Q₁₇ und den Spannungsteiler R₂₄ und R₂₅ wird bewirkt, daß der Transistor Q₁₉ in den leitenden Zustand übergeht; dadurch sinkt aber das Kollektorpotential des Transistors Q₁₉ stark ab (ungefähr bis auf die Kollektor-Emitter-Restspannung U_{CE Rest}). Folglich wird der Zweig Diode Q₁₆ und R₂₉ leitend, wodurch wiederum der Spannungsteiler R₂₂, Q₁₅, R₂₃ durch diesen Zweig belastet wird, so daß das Basispotential des Transistors Q₁₄ bzw. das Basispotential des Transistors Q₁₁ bis zum Punkt P₁ absinkt. Für einen neuen Einschaltvorgang muß demnach die Spannung U₃ die Einschaltschwelle Uₑᵢₙ unterschreiten.
Die Hysterese ist durch den Spannungsunterschied AU zwischen der Einschaltschwelle Uₑᵢₙ (Punkt P₁) und der Ausschaltschwelle Uₐᵤₛ (Punkt P₂) gegeben.
Durch Variation des Widerstands R₂₉ kann der Punkt P₁, d.h. die Einschaltschwelle des Opto-Schmitt-Triggers individuell verändert werden, ohne daß der Punkt P₂, d.h. die Ausschaltschwelle, verändert wird. Durch Variation der Widerstände R₂₂ und R₂₃ kann der Punkt P₂, d.h. die Ausschaltschwelle des Opto-Schmitt-Triggers, verschoben werden.

### 4. Ausgangsstufe :

Die Ausgangsstufe 4 besteht aus dem Emitterfolger-Transistor Q₁₈, dessen Basis an die Widerstände R₂₆, R₂₉ und den Kollektor des Transistors Q₁₉ angeschlossen ist, aus dem Spannungsteiler R₂₇, R₂₈ und dem beispielsweise als Open-Kollektor-Transistor ausgebildeten Ausgangstransistor Q₂₀. Der Emitter des Emitterfolger-Transistors Q₁₈ ist an den Widerstand R₂₇ angeschlossen, die Basis des Ausgangstransistors Q₂₀ an den Abgriff des Spannungsteilers R₂₇, R₂₈; der Kollektor des Emitterfolger-Transistors Q₁₈ ist mit der Versorgungsspannung(+ 5 V), der zweite Anschluß des Widerstands R₂₈ sowie der Emitter des Ausgangstransistors Q₂₀ mit Massepotential (GND) verbunden. Der Verlauf der Spannung (U₄) am Schaltungsausgang A der Ausgangsstufe 4 (des Opto-Schmitt-Triggers) ist in der untersten Kurve der Fig. 3 wiedergegeben, wobei der HIGH-Zustand beispielsweise durch die Versorgungsspannung (+ 5 V) und der LOW-Zustand durch die Restspannung U_{Rest} des Ausgangstransistors Q₂₀ gegeben ist.
Bei der Detektion von Licht (Punkt P₁) sperrt nach obigen Ausführungen der Transistor Q₁₉, so daß über den Emitterfolger-Transistor Q₁₈ der Ausgangstransistor Q₂₀ leitet; der Schaltungsausgang A befindet sich somit im LOW-Zustand. Der Open-Kollektor-Schaltungsausgang A kann über einen Lastwiderstand R_{L} an die Versorgungsspannung (+5 V) angeschlossen werden, wobei der Lastwiderstand R_{L} individuell für den jeweiligen Anwendungszweck vorgegeben werden kann.
Nach Unterschreiten der Mindest-Bestrahlung (Punkt P2) wird der Transistor Q₁₉ leitend, so daß der Emitterfolger-Transistor Q₁₃ und damit der Ausgangstransistor Q₂₀ sperrt; der Schaltungsausgang A geht dann in den HIGH-Zustand über.
Statt eines Open-Kollektor-Schaltungsausgangs A können jedoch auch beliebige andere Schaltungsausgänge - je nach Erfordernis und Anwendungsmöglichkeiten - eingesetzt werden.

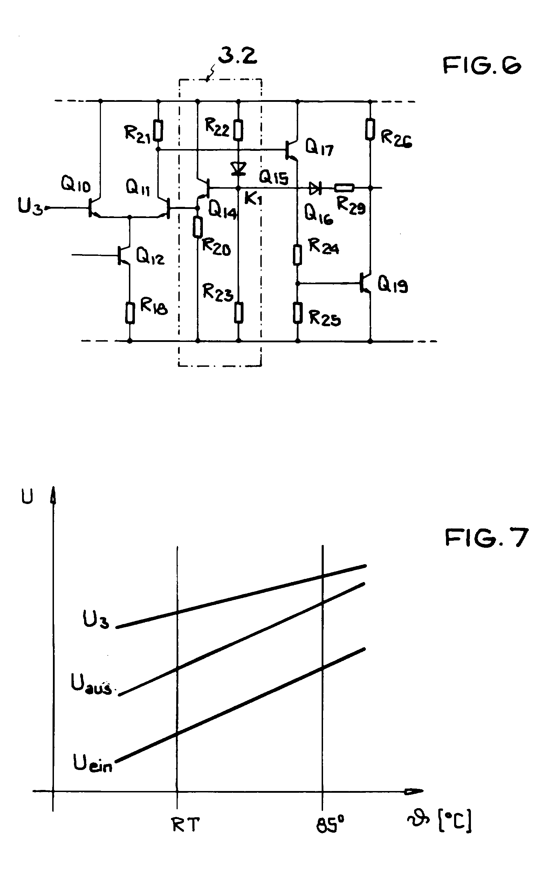

### Beispiel 2: "active-HIGH"-Version (Fig. 4 und 5)

In der "active-HIGH"-Version des Opto-Schmitt-Triggers schaltet der Ausgangstransistor Q₂₀ bei Erzeugung eines Fotostroms in den HIGH-Zustand, d.h. der Schaltungsausgang A der Ausgangsstufe 4 nimmt beim Vorhandensein einer Lichterregung den HIGH-Zustand und bei Wegfall der Lichterregung den LOW-Zustand ein.
Die hierzu benötigte Schaltungsanordnung ist gemäß Fig. 4 gegenüber der "active-LOW"-Version in der Figur 2 nur geringfügig in der Differenzverstärkerstufe 2.3 modifiziert; der Widerstand R7 ist nicht mehr, wie in Figur 2, der Kollektorwiderstand des Transistors Q₅, sondern wie in Figur 4 dargestellt, der Kollektorwiderstand des Transistors Q₆.
Der Potentialabgriff dieser beiden Transistoren Q₅, Q₆ wird also gerade vertauscht; demzufolge verläuft die Spannung U₃ am Ausgang der Verstärkerstufe 2 gerade entgegengesetzt zu derjenigen der "active-LOW"-Version. Die der Figur 3 entsprechenden Potentialverläufe der "active-LOW"-Version sind für die ,,active-HIGH"-Version in der Figur 5 dargestellt. Durch Variation der Widerstände R₂₂ und R₂₃ kann der Punkt P₁, d.h. die Ausschaltschwelle Uₐᵤₛ (Ausgangstransistor Q₂₀ ausgeschaltet), durch Variation des Widerstands R₂₉ der Punkt P₂, d.h. die Einschaltschwelle Uₑᵢₙ (Ausgangstransistor Q₂₀ eingeschaltet) verschoben werden.

Der Anwender kann sich somit, je nach Erfordernis, entweder für die ,,active-LOW"-Version oder für die "active-HIGH"-Version entscheiden.

### Beispiel 3: Gezielt temperaturabhängige Einschaltschwelle bei "active-LOW"-Version (Fig. 6 und 7)

In der Figur 6 ist eine Schaltungsvariante gegenüber der "active-LOW"-Version in Figur 2 dargestellt, bei der durch eine Variation im Referenznetzwerk 3.2 der Schmitt-Trigger-Stufe 3 erreicht wird, daß deren Schwellwerte mit zunehmender Temperatur zunehmen. Hierzu wird die Diode Q₁₅ nicht wie in Figur 2, zwischen dem Knotenpunkt K₁ und dem Widerstand R23, sondern zwischen dem Knotenpunkt K₁ und dem Widerstand R₂₂ angeordnet; dadurch kann ein gezielter Temperaturgang der Schwellwerte (Ein- und Ausschaltschwelle) vorgegeben werden
Die Einschaltschwelle Uₑᵢₙ wird deswegen gezielt in Abhängigkeit der Temperatur verändert, um, falls der Opto-Schmitt-Trigger in Lichtschranken eingesetzt wird, den Tempertureinfluß der optischen Strecke LED-Fotodiode zu kompensieren: die Strahlungsleistung der LED nimmt bei steigender Temperatur ab, was durch die steigende Empfindlichkeit der Fotodiode nur unzureichend ausgeglichen wird, so daß mit steigender Temperatur letztendlich durch die Fotodiode weniger Fotostrom geliefert wird. Diesem Effekt kann durch eine Erhöhung der Einschaltempfindlichkeit gegengesteuert werden.

In der Figur 7 ist die Spannung U₃ am Ausgang der Verstärkerstufe 2, die Ausschaltschwelle Uₐᵤₛ und die Einschaltschwelle Uₑᵢₙ der Schmitt-Trigger-Stufe 3 über der Temperatur 9 aufgetragen. Es wird ersichtlich, daß die Steigung der Geraden Uₑᵢₙ (9) steiler als die der Geraden U₃ (9) verläuft, wodurch die Einschaltempfindlichkeit mit steigender Temperatur 9 zunimmt.

### Beispiel 4: Differenzbildung zweier Fotoströme

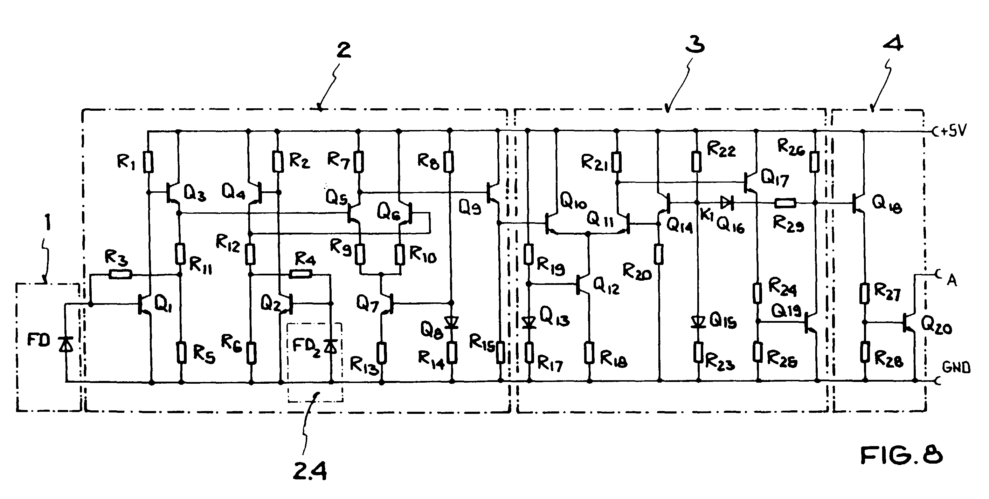

In einer weiteren Schaltungsvariante, die in der Figur 8 dargestellt ist, wird der Kompensations-Kondensator C im Kompensationsglied 2.4 der Verstärkerstufe 2 durch eine weitere Fotodiode FD2 ersetzt. Mit dieser Schaltungsanordnung kann dann die Differenz zweier Fotoströme ausgewertet und am Schaltungsausgang A der Ausgangsstufe 4 ausgegeben werden.

Die Empfindlichkeit der beschriebenen Opto-Schmitt-Trigger beträgt bei Raumtemperatur ca. 0,6 mW/cm² bei einer Wellenlänge von 950 nm; dies bedeutet, daß der Opto-Schmitt-Trigger bei dieser angegebenen Strahlungsleistung die Schaltschwelle Uₑᵢₙ erreicht.

## Patentansprüche

1. Schaltungsanordnung, bei der mittels eines Fotoempfangselements (1), einer eine Transimpedanzverstärkerstufe (2.1), eine Differenzverstärkerstufe (2.3), ein erstes Referenznetzwerk (2.2) sowie ein Kompensationsglied (2.4) aufweisenden Verstärkerstufe (2), und einer Ausgangsstufe (4) ein optisches Eingangssignal in ein am Schaltungsausgang (A) der Ausgangsstufe (4) anliegendes elektrisches Ausgangssignal umgewandelt wird, wobei der vom Fotoempfangselement (1) abgegebene Fotostrom durch einen Konversionswiderstand (R3) der Transimpedanzverstärkerstufe (2.1) in eine elektrische Spannung (U₂) umgewandelt wird, die von der Differenzverstärkerstufe (2.3) der Verstärkerstufe (2) verstärkt wird, dadurch gekennzeichnet, daß bei der als Opto-Schmitt-Trigger ausgebildeten Schaltungsanordnung zwischen der Verstärkerstufe (2) und der Ausgangsstufe (4) eine Schmitt-Trigger-Stufe (3) aus einer Differenzverstärkerstufe (3.1), einem zweiten Referenznetzwerk (3.2) und einem Mitkopplungszweig (3.3) angeordnet ist, wobei
- die Ausgangsspannung (U₃) der Verstärkerstufe (2) der Schmitt-Trigger-Stufe (3) über einen Emitterfolger-Transistor (Q₉) der Differenzverstärkerstufe (2.3) der Verstärkerstufe (2) zugeführt wird,
- die Differenzverstärkerstufe (3.1) der Schmitt-Trigger-Stufe (3) Transistoren (Q₁₀, Q₁₁, Q₁₂), Widerstände (R₁₇, R₁₈, R₁₉) und eine Diode (Q₁₃) enthält, wobei die Ausgangsspannung (U₃) der Verstärkerstufe (2) auf die Basis eines Transistors (Q₁₀) des Differenzverstärkers der Differenzverstärkerstufe (3.1) der Schmitt-Trigger-Stufe (3) gegeben wird,
- das zweite Referenznetzwerk (3.2) der Schmitt-Trigger-Stufe (3) einen Emitterfolger-Transistor (Q₁₄), Widerstände (R₂₃, R₂₀, R₂₂) und eine Diode (Q₁₅) enthält, wobei die Basis eines der Transistoren (Q₁₁) des Differenzverstärkers der Differenzverstärkerstufe (3.1) der Schmitt-Trigger-Stufe (3) mit dem Emitter des Emitterfolger-Transistors (Q₁₄) verbunden ist,
- der Mitkopplungszweig (3.3) der Schmitt-Trigger-Stufe (3) einen Emitterfolger-Transistor (Q₁₇) und einen Transistor (Q₁₉) in Emitterschaltung aufweist, durch die die am Kollektorabgriff eines der Transistoren (Q₁₁) des Differenzverstärkers der Differenzverstärkerstufe (3.1) der Schmitt-Trigger-Stufe (3) anstehende Spannung auf die Ausgangsstufe (4) übertragen wird, wobei das Ausgangssignal des Mitkopplungszweigs (3.3) über einen ersten Widerstand (R₂₉) und eine Diode (Q₁₆) auf die Basis des Emitterfolger-Transistors (Q₁₄) im zweiten Referenznetzwerk (3.2) rückgekoppelt wird,
- die Ausgangsstufe (4) einen Emitterfolger-Transistor (Q₁₈) und einen Ausgangstransistor (Q₂₀) aufweist, an dem die Ausgangsspannung (U₄) entweder als HIGH-Pegel oder als LOW-Pegel ausgegeben wird, indem der Ausgangstransistor (Q₂₀) eingeschaltet ist, wenn die Ausgangsspannung (U₃) der Verstärkerstufe (2) einen ersten vorgegebenen Schwellwert als Einschaltschwelle (Uₑᵢₙ) unterschreitet und ausgeschaltet ist, wenn die Ausgangsspannung (U₃) der Verstärkerstufe (2) einen zweiten vergebenen Schwellwert als Ausschaltschwelle (Uₐᵤₛ) überschreitet, wobei die Ausschaltschwelle (Uₐᵤₛ) durch Variation zweier Widerstände (R₂₂, R₂₃) eines Spannungsteilers im zweiten Referenznetzwerk (3.2) der Schmitt-Trigger-Stufe (3) geändert werden kann, und die Einschaltschwelle (Uₑᵢₙ) durch Variation des ersten Widerstandes (R₂₉) im Mitkopplungszweig (3.3) der Schmitt-Trigger-Stufe (3) geändert werden kann, ohne daß die Ausschaltschwelle (Uₐᵤₛ) verändert wird.

2. Schaltungsanordnung nach Anspruch 1, dadurch gekennzeichnet, daß ein Kollektorwiderstand (R7) am Kollektor des ersten Transistors (Q₅) der beiden den Differenzverstärker (Q₅, Q₆) der Differenzverstärkerstufe (2.3) der Verstärkerstufe (2) bildenden Transistoren angeschlossen ist (Fig. 2), und daß am Schaltungsausgang (A) beim Überschreiten einer Mindest-Strahlung (P₁) auf das Fotoempfangselement (1) ein LOW-Pegel und beim Unterschreiten der Mindest-Strahlung (P₂) ein HIGH-Pegel anliegt (Fig. 3).

3. Schaltungsanordnung nach Anspruch 1, dadurch gekennzeichnet, daß ein Kollektorwiderstand (R7) am Kollektor des zweiten Transistors (Q₆) der beiden den Differenzverstärker (Q₅, Q₆) der Differenzverstärkerstufe (2.3) der Verstärkerstufe (2) bildenden Transistoren angeschlossen ist (Fig. 4), und daß am Schaltungsausgang (A) beim Überschreiten einer Mindest-Strahlung (P₁) auf das Fotoempfangselement (1) ein HIGH-Pegel und beim Unterschreiten der Mindest-Strahlung (P₂) ein LOW-Pegel anliegt (Fig. 5).

4. Schaltungsanordnung nach einem der Ansprüche 1 bis 3, dadurch gekennzeichnet, daß im Referenznetzwerk (3.2) der Schmitt-Trigger-Stufe (3) die Anode der Diode (Q₁₅) mit einem an die Versorgungsspannung angeschlossenen Widerstand (R₂₂) und die Kathode der Diode (Q₁₅) mit einem Knotenpunkt (K₁) verbunden ist, und daß die Einschaltschwelle (Uₑᵢₙ) und die Ausschaltschwelle (Uₐᵤₛ) der Schmitt-Trigger-Stufe (3) mit steigender Temperatur schneller als die Ausgangsspannung (U₃) der Verstärkerstufe (2) zunimmt (Fig. 6 und 7).

5. Schaltungsanordnung nach einem der Ansprüche 1 bis 4, dadurch gekennzeichnet, daß die Ausgangsstufe (4) als Open-Kollektor-Ausgangsstufe, Kollektor-Ausgangsstufe oder Totem-Pole-Ausgangsstufe ausgebildet ist.

6. Schaltungsanordnung nach einem der Ansprüche 1 bis 5, dadurch gekennzeichnet, daß der LOW-Pegel durch die Restspannung (U_{Rest}) des Ausgangstransistors (Q₂₀) der Ausgangsstufe (4) und der HIGH-Pegel im wesentlichen durch den Spannungspegel der Versorgungsspannung gegeben ist.

## Claims

1. Circuit arrangement in which an optical input signal is converted into an electrical output signal at the circuit output point (A) of the output stage (4) by means of a photoelectric receiving element (1), an output stage (4) and an amplifier stage (2) comprising a transimpedance amplifier stage (2.1), a differential amplifier stage (2.3), a first reference network (2.2) and a compensating member (2.4), wherein the photocurrent supplied by the photoelectric receiving element (1) is converted into an electrical voltage (U₂) by a converting resistor (R₃) in the transimpedance amplifier stage (2.1), which voltage is amplified by the differential amplifier stage (2.3) of the amplifier stage (2), characterised in that, a Schmitt trigger stage (3) consisting of a differential amplifier stage (3.1), a second reference network (3.2) and a regenerative feedback path (3.3) is disposed between the amplifier stage (2) and the output stage (4) in the circuit arrangement which is constructed in the form of an optical Schmitt trigger, wherein
- the output voltage (U₃) of the amplifier stage (2) is supplied to the Schmitt trigger stage (3) via an emitter follower transistor (Q₉) in the differential amplifier stage (2.3) of the amplifier stage (2),
- the differential amplifier stage (3.3) of the Schmitt trigger stage (3) includes transistors (Q₁₀, Q₁₁, Q₁₂), resistor (R₁₇, R₁₈, R₁₉) and a diode (Q₁₃) and therein the output voltage (U₃) of the amplifier stage (2) is passed to the base of a transistor (Q₁₀) in the differential amplifier of the differential amplifier stage (3.1) of the Schmitt trigger stage (3),
- the second reference network (3.2) of the Schmitt trigger stage (3) includes an emitter follower transistor (Q₁₄), resistors (R₂₃, R₂₀, R₂₂) and a diode (Q₁₅) and wherein the base of one of the transistors (Q₁₁) in the differential amplifier of the differential amplifier stage (3.1) of the Schmitt trigger stage (3) is connected to the emitter of the emitter follower transistor (Q₁₄),
- the regenerative feedback path (3.3) of the Schmitt trigger stage (3) comprises an emitter follower transistor (Q₁₇) and a transistor (Q₁₉) connected in grounded emitter configuration through which the voltage occurring at the collector tapping of one of the transistors (Q₁₁) in the differential amplifier of the differential amplifier stage (3.1) of the Schmitt trigger stage (3) is transferred to the output stage (4), and wherein the output signal of the regenerative feedback path (3.3) is fed back via a first resistor (R₂₉) and a diode (Q₁₆) to the base of the emitter follower transistor (Q₁₄) in the second reference network (3.2),
- the output stage (4) comprises an emitter follower transistor (Q₁₈) and an output transistor (Q₂₀) to which the output voltage (U₄) is applied as either a HIGH level or a LOW level signal so that the output transistor (Q₂₀) is switched on when the output voltage (U₃) of the amplifier stage (2) falls below a first predetermined threshold value forming a switch-on threshold (Uₒₙ) and is switched off when the output voltage (U₃) of the amplifier stage (2) exceeds a second predetermined threshold value forming a switch-off threshold (U_{off}) and wherein the switch-off threshold (U_{off}) can be altered by varying two resistors (R₂₂, R₂₃) of a voltage divider in the second reference network (3.2) of the Schmitt trigger stage (3) and the switch-on threshold (Uₒₙ) can be altered by varying the first resistor (R₂₉) in the regenerative feedback path (3,3) of the Schmitt trigger stage (3) without thereby altering the switch-off threshold (U_{off}).

2. Circuit arrangement in accordance with Claim 1, characterised in that, a collector resistor (R₇) is connected to the collector of the first transistor (Q₅) of the two transistors forming the differential amplifier (Q₅, Q₆) in the differential amplifier stage (2.3) of the amplifier stage (2) (Fig. 2) and that a LOW level is present at the circuit output point (A) when a minimum level of radiation (P₁) on the photoelectric receiving element (1) is exceeded and that a HIGH level is present when the radiation level is below the minimum level of radiation (P₂) (Fig. 3).

3. Circuit arrangement in accordance with Claim 1, characterised in that, a collector resistor (R₇) is connected to the collector of the second transistor (Q₆) of the two transistors forming the differential amplifier (Q₅, Q₆) in the differential amplifier stage (2.3) of the amplifier stage (2) (Fig. 4) and that a HIGH level is present at the circuit output point (A) when a minimum level of radiation (P₁) on the photoelectric receiving element (1) is exceeded and that a LOW level is present when the radiation level is below the minimum level of radiation (P₂) (Fig. 5).

4. Circuit arrangement in accordance with any of Claims 1 to 3, characterised in that, the anode of the dicde (Q₁₅) in the reference network (3.2) of the Schmitt trigger stage (3) is connected to a resistor (R₂₂) which is connected to the supply voltage and the cathode of the diode (Q₁₅) ii connected to a nodal point (K₁) and that the switch-on threshold (Uₒₙ) and the switch-off threshold (U_{off}) of the Schmitt trigger stage (3) increases more rapidly than the output voltage (U₃) of the amplifier stage (2) with increasing temperature (Figs. 6 and 7).

5. Circuit arrangement in accordance with any of the Claims 1 to 4, characterised in that, the output stage (4) is constructed as an open collector output stage, a collector output stage or a totem-pole output stage.

6. Circuit arrangement in accordance with any of the Claims 1 to 5, characterised in that, the LOW level is provided by the quiescent voltage (Uᵣₑₛₜ) of the output transistor (Q₂₀) in the output stage (4) and the HIGH level, in essence, by the voltage level of the supply voltage.

## Revendications

1. Circuit, dans lequel au moyen d'un élément photorécepteur (1) d'un étage amplificateur (2) comportant un étage amplificateur différentiel (2.3), un premier réseau de référence (2.2) ainsi qu'un élément de compensation (2.4), et d'un étage de sortie (4) un signal d'entrée optique est converti en un signal de sortie électrique apparaissant à la sortie (A) de l'étage de sortie (4), le photocourant délivré par l'élément photorécepteur (1) est converti par une résistance de conversion (R₃) de l'étage amplificateur à impédance de transfert (2.1) en une tension électrique (U₂), qui est amplifiée par l'étage amplificateur différentiel (2.3) de l'étage amplificateur (2), caractérisé en ce que dans le cas du circuit réalisé en tant que bascule de Schmitt optique est disposé entre l'étage amplificateur (2) et l'étage de sortie (4) un étage de bascule de Schmitt (3) se composant d'un étage amplificateur différentiel (3.1), d'un second réseau de référence (3.2) et d'une dérivation à réaction positive (3.3),
- la tension de sortie (U₃ de l'étage amplificateur (2) de l'étage de bascule de Schmitt (3) est appliquée par l'intermédiaire d'un transistor à émetteur asservi (Q₉) à l'étage amplificateur différentiel (2.3) de l'étage amplificateur (2),
- l'étage amplificateur différentiel (3.1) de l'étage de bascule de Schmitt (3) comporte des transistors (Q₁₀, Q₁₁, Q₁₂), des résistances (R₁₇, R₁₈, R₁₉) et une diode (Q₁₃), la tension de sortie (U₃) de l'étage amplificateur (2) est appliquée à la base d'un transistor (Q₁₀) de l'amplificateur différentiel de l'étage amplificateur différentiel (3.1) de l'étage de bascule de Schmitt (3),
le second réseau de référence (3.2) de l'étage de bascule de Schmitt (3) contient un transistor à émetteur asservi (Q₁₄), des résistances (R₂₃, R₂₀, R₂₂) et une diode (Q₁₅), la base d'un des transistors (Q₁₁) de l'amplificateur différentiel de l'étage amplificateur différentiel (3.1) de l'étage de bascule de Schmitt (3) étant reliée à l'émetteur du transistor à émetteur asservi (Q₁₄),
- la dérivation à réaction positive (3.3) de l'étage de bascule de Schmitt (3) présente un transistor à émetteur asservi (Q₁₇ et un transistor (Q₁₉) dans le circuit d'émetteur, par l'intermédiaire duquel la tension apparaissant à la prise de collecteur d'un des transistors (Q₁₁) de l'amplificateur différentiel de l'étage amplificateur différentiel (3.1) de l'étage de bascule de Schmitt (3) est transmise à l'étage de sortie (4), le signal de sortie de la dérivation à réaction positive (3.3) est réappliqué par l'intermédiaire d'une première résistance (R₂₉) et d'une diode (Q₁₆) à la base du transistor à émetteur asservi (Q₁₄) dans le second réseau de référence (3.2),
l'étage de sortie (4) comporte un transistor à émetteur asservi (Q₁₈) et un transistor de sortie (Q₂₀), auquel est délivrée la tension de sortie (U₄) soit en tant que niveau HAUT, soit en tant que niveau BAS, dans lequel le transistor de sortie (Q₂₀) est rendu conducteur lorsque la tension de sortie (U₃) de l'étage amplificateur (2) passe au-dessous d'une première valeur de seuil prédéterminée en tant que seuil de mise en marche (U_{marche}) et est bloqué, lorsque la tension de sortie (U₃) de l'étage amplificateur (2) franchit une deuxième valeur de seuil prédéterminée en tant que valeur de seuil de coupure (U_{coupure}), le seuil de coupure (U_{coupure}) pouvant être modifié par variation de deux résistances (R₂₂, R₂₃) d'un diviseur de tension dans le second réseau de référence (3.2) de l'étage de bascule de Schmitt (3), et le seuil de mise en marche (U_{marche}) étant modifié par variation de la première résistance (R₂₉) dans la dérivation à réaction positive (3.3) de l'étage de bascule de Schmitt (3), sans que le seuil de coupure (U_{coupure}) soit modifié.

2. Circuit selon la revendication 1, caractérisé en ce qu'une résistance de collecteur (R₇) est reliée au collecteur du premier transistor (Q₅) des deux transistors formant l'amplificateur différentiel (Q₅, Q₆) de l'étage amplificateur différentiel (2.3) de l'étage amplificateur (2) (Figure 2), et en ce qu'à la sortie du circuit (A), lors du dépassement d'un rayonnement minimal (P₁) sur l'élément photorécepteur (1), se trouve un niveau BAS et dans le cas du passage au-dessous du rayonnement minimal (P₂) se trouve un niveau HAUT (Figure 3).

3. Circuit selon la revendication 1, caractérisé en ce qu'une résistance de collecteur (R₇) est reliée (Figure 4) au collecteur du second transistor (Q₆) des deux transistors formant l'amplificateur différentiel (Q₅, Q₆) de l'étage amplificateur différentiel (2.3) de l'étage amplificateur (2), et en ce qu'à la sortie (A), lors du dépassement d'un rayonnement minimal (P₁) sur l'élément photorécepteur (1) apparaît un niveau HAUT et dans le cas du passage au-dessous du rayonnement minimal (P₂) apparaît un niveau BAS (Figure 5).

4. Circuit selon l'une des revendications 1 à 3, caractérisé en ce que, dans le réseau de référence (3.2) de l'étage de bascule de Schmitt (3), l'anode de la diode (Q₁₅) est reliée à une résistance (R₂₂) reliée à la tension d'alimentation et la cathode de la diode (Q₁₅) à un noeud (K1) et en ce que le seuil de mise en marche (U_{marche}) et le seuil de coupure (U_{coupure}) de l'étage de bascule de Schmitt (3) croît à température croissante plus rapidement que la tension de sortie (U₃) de l'étage amplificateur (2) (Figures 6 et 7).

5. Circuit selon l'une des revendications 1 à 4, caractérisé en ce que l'étage de sortie (4) est réalisé en tant qu'étage de sortie à collecteur ouvert, en tant qu'étage de sortie à collecteur ou en tant qu'étage de sortie à poteau de totem.

6. Circuit selon l'une des revendications 1 à 5, caractérisé en ce que le niveau BAS est déterminé par la tension résiduelle (U_{residuelle}) du transistor de sortie (Q₂₀) de l'étage de sortie (4) et le niveau HAUT essentiellement par le niveau de tension de la tension d'alimentation.
